Europäisches Patentamt

(19) European Patent Office

Office européen des brevets

(11) Numéro de publication : **0 112 227
B1**

(12) **FASCICULE DE BREVET EUROPÉEN**

(45) Date de publication du fascicule du brevet :
11.02.87

(51) Int. Cl.⁴ : **H 01 L 33/00, H 04 B   9/00**

(21) Numéro de dépôt : **83402323.6**

(22) Date de dépôt : **02.12.83**

(54) Dispositif à diode émettrice de lumière aménagé pour supprimer les effets de constante de temps thermique.

(30) Priorité : 14.12.82 FR 8220965

(43) Date de publication de la demande :
27.06.84 Bulletin 84/26

(45) Mention de la délivrance du brevet :
11.02.87 Bulletin 87/07

(84) Etats contractants désignés :
BE CH DE GB LI

(56) Documents cités :
US-A- 3 755 679
US-A- 4 243 952
US-A- 4 359 773

(73) Titulaire : THOMSON-CSF
173, Boulevard Haussmann
F-75379 Paris Cedex 08 (FR)

(72) Inventeur : Eumurian, Grégoire
THOMSON-CSF SCPI 173, bld Haussmann
F-75379 Paris Cedex 08 (FR)

(74) Mandataire : Trocellier, Roger et al
THOMSON-CSF SCPI 19, avenue de Messine
F-75008 Paris (FR)

Jouve, 18, rue St-Denis, 75001 Paris, France

**0 112 227**

## Description

La présente invention concerne un dispositif à diode émettrice de lumière aménagée pour supprimer les effets de constante de temps thermique.

Les diodes émettrices de lumière sont souvent désignées sous le vocable abrégé DEL ou LED (de l'anglais « Light Emitting Diode »). Elles constituent un des composants les plus utilisés dans les transmissions par fibres optique. Ce composant présente en effet une caractéristique de réponse courant-puissance linéaire et, une modulation de la puissance optique par variation du courant peut être obtenue dans une large gamme de fréquence, les fréquences hautes pouvant aisément se situer ver 150 à 200 MHz dans les conditions technologiques actuelles.

Les systèmes de transmission, ou bus optiques, font généralement intervenir plusieurs émetteurs à diode DEL ainsi que plusieurs récepteurs optiques, chaque récepteur étant équipé d'une photodiode PIN ou à avalanche.

On rappellera tout d'abord quelques propriétés des dispositifs émetteurs et récepteurs optiques pour faciliter l'exposé et la compréhension de l'objet de l'invention.

Dans le cas d'une transmission analogique, la diode DEL est polarisée en direct avec un courant Io correspondant à la valeur moyenne de la zone de modulation parcourue sur la caractéristique courant-puissance. La modulation est réalisée en faisant varier le courant et donc la puissance, de part et d'autre de cette valeur moyenne.

Dans le cas d'une transmission numérique, il est possible d'effectuer une modulation par rapport à zéro, par exemple $1 = 0$ et $P = 0$ représentent le « zéro » logique et, $1 = l1$ et $P = P1$ le « un » logique. Toutefois, pour la plupart des diodes LED, une modulation par tout ou rien entraîne une mauvaise réponse impulsionnelle et il est préférable d'effectuer une modulation avec deux niveaux ce qui revient à une polarisation sur la valeur moyenne Io du courant. Cette valeur moyenne est avantageusement utilisée dans les cas fréquents d'un codage à trois niveaux de la transmission pour définir le troisième niveau ou niveau intermédiaire, les deux autres étant ceux correspondant à l'état « un » et à l'état « zéro ».

Après transmission par fibre optique, la puissance est démodulée à l'aide d'une photodiode. Cette photodiode est soit du type PIN, soit à avalanche. Dans les deux cas le bruit optique dépend de la valeur de la puissance moyenne de modulation.

Pour obtenir le rapport signal sur bruit le plus élevé, il est nécessaire de moduler au maximum la diode LED et de minimiser au maximum la puissance optique moyenne.

Si la lumière arrivant au récepteur provient d'un seul émetteur, le rapport entre ces deux paramètres définissant le taux de modulation est constant et compris entre 0 et 100 % (valeur typique 50 %). Pour une valeur fixée du taux de modulation, le rapport signal sur bruit augmente comme la racine carrée de la puissance moyenne.

Si la lumière arrivant au récepteur provient d'une pluralité n d'émetteurs (cas des bus optiques), le rapport signal sur bruit est donné par une relation qui fait intervenir

$$\frac{\Delta Pi}{\sqrt{Pol + \cdots + Poi + \cdots + Pon}}$$

où $\Delta Pi$ est la modulation de l'émetteur i et Poi est la puissance moyenne émise par l'émetteur i. La modulation de l'émetteur peut ainsi être noyée dans le bruit produit par l'ensemble des émetteurs 1 à n. La dégradation de la dynamique est proportionnelle à $\sqrt{n}$ dans le cas de puissances considérées égales car alors le rapport peut s'écrire

$$\frac{\Delta Pi}{\sqrt{nPo}} \cdot$$

La puissance électrique $PE = I \cdot VD$ dissipée par une diode DEL dépend du courant I qu'on lui injecte ainsi que de sa chute en tension VD. Cette puissance, dissipée au niveau de la jonction, produit une élévation de température entraînant une chute de la puissance optique émise. La température TJ de la jonction dépend de la puissance électrique PE, de la température ambiante TA, de la résistance thermique jonction-ambiante $Rth_{J-A}$ et peut être exprimée sous la forme :

$$Tj = PE \cdot Rth_{J-A} + TA$$

Si la puissance électrique appliquée à la diode varie en fonction du temps, la température de la jonction suit avec une constante de temps qui peut être définie par le produit $Rth_{J-A} \cdot Cth_{J-A}$ où $Cth_{J-A}$ représente la capacité thermique jonction-ambiante.

A cette variation dans le temps la température de la jonction correspond une variation de la puissance optique émise, effet parasite indésirable faussant la modulation de la diode.

2

# 0 112 227

Un objet de la présente invention est de remédier à cet effet de constante de temps thermique, ainsi qu'à la dégradation du rapport signal sur bruit précédemment signalée dans une utilisation à plusieurs émetteurs et récepteurs optiques (bus optiques).

En effet, dans ces cas d'utilisation, le système peut être organisé pour fonctionner de deux manières différentes :

Suivant un premier mode, un seul émetteur est modulé mais tous les émetteurs émettent leur puissance moyenne. Dans ce cas tous les émetteurs sont polarisés mais, seul l'émetteur choisi pour transmettre reçoit sa modulation. De cette manière, un émetteur en état d'attente (donc déjà polarisé) ne fait pas intervenir sa constante de temps thermique au moment où il est sollicité, sa puissance moyenne étant constamment établie à la valeur d'équilibre. Toutefois, le récepteur reçoit la puissance optique moyenne émise par l'ensemble des émetteurs et produit un maximum de bruit. Avec, par exemple, dix émetteurs d'égale puissance le rapport signal sur bruit se dégrade de 10 db.

Suivant le second mode possible de fonctionnement, un seul émetteur est modulé, tous les autres sont coupés. Dans ce cas, le rapport signal sur bruit au niveau du récepteur n'est pas dégradé mais, chaque fois qu'un émetteur est sollicité, il faut attendre un temps relativement long pour que la stabilisation thermique puisse se produire. Pour une transmission à débit élevé (10 à 100 Mbits/S), ce temps mort peut représenter plusieurs millions ou milliards de bits.

On constate donc qu'aucun de ces deux modes n'apporte une solution pour les systèmes de transmission à émetteurs multiples.

Une solution conforme à l'invention permet d'obtenir un rapport signal sur bruit aussi bon que dans le deuxième mode mais avec une vitesse de commutation proche de celle du premier mode.

Selon l'invention, il est proposé un dispositif à diode émettrice de lumière comportant un moyen de mise en service et de modulation de la diode sur réception d'un signal de modulation, ce moyen polarisant la diode en direct pour obtenir une émission de photons modulés selon le signal, et un moyen de mise hors service de la diode durant les intervalles de temps séparant les périodes d'émission, le dispositif étant caractérisé en ce que le moyen de mise hors service est déterminé pour polariser en inverse la diode en dissipant dans sa jonction pn, une puissance électrique sensiblement égale à la valeur de celle qui y est dissipée durant chaque émission, et placer, ainsi la diode en un état de veille durant lequel l'émission se trouve bloquée tout en assurant une température de la jonction correspondant à celle durant l'émission ce qui permet d'éviter tout effet de constante de temps thermique de la jonction.

Les particularités et avantages de la présente invention apparaîtront dans la description qui suit donnée à titre d'exemple non limitatif à l'aide des figures annexées qui représentent :

Figure 1   des formes d'ondes relatives au fonctionnement et au procédé mis en œuvre :

Figure 2   un schéma électrique d'un exemple de réalisation d'un dispositif à diode DEL conforme à l'invention ;

Figure 3   un schéma partiel du circuit Fig. 2 relatif au circuit équivalent en état de veille ;

Figure 4   la caractéristique tension-courant en inverse de la diode DEL et la détermination du point de fonctionnement ;

Figure 5   un diagramme d'une utilisation du dispositif à diode DEL selon l'invention dans un bus optique.

Le procédé utilisé consiste à polariser en inverse la diode DEL durant toute la période de repos et ceci de manière à ce que la puissance électrique dissipée au niveau de sa jonction soit identique à la puissance électrique qu'elle va dissiper quand elle sera polarisée en direct, c'est-à-dire durant une période de fonctionnement.

Dans une première phase (phase d'attente ou de veille), la diode étant contre-polarisée, il n'y a pas d'émission optique. Par contre, la jonction se trouve déjà à la température de travail nécessaire pour la deuxième phase (phase d'émission).

Dans ces conditions, la diode n'émet pas de lumière en état de veille, n'augmentant pas le bruit au niveau du récepteur. Dans la phase d'émission, la température de jonction étant correcte, il n'y a pas de constante de temps thermique retardant l'état d'équilibre.

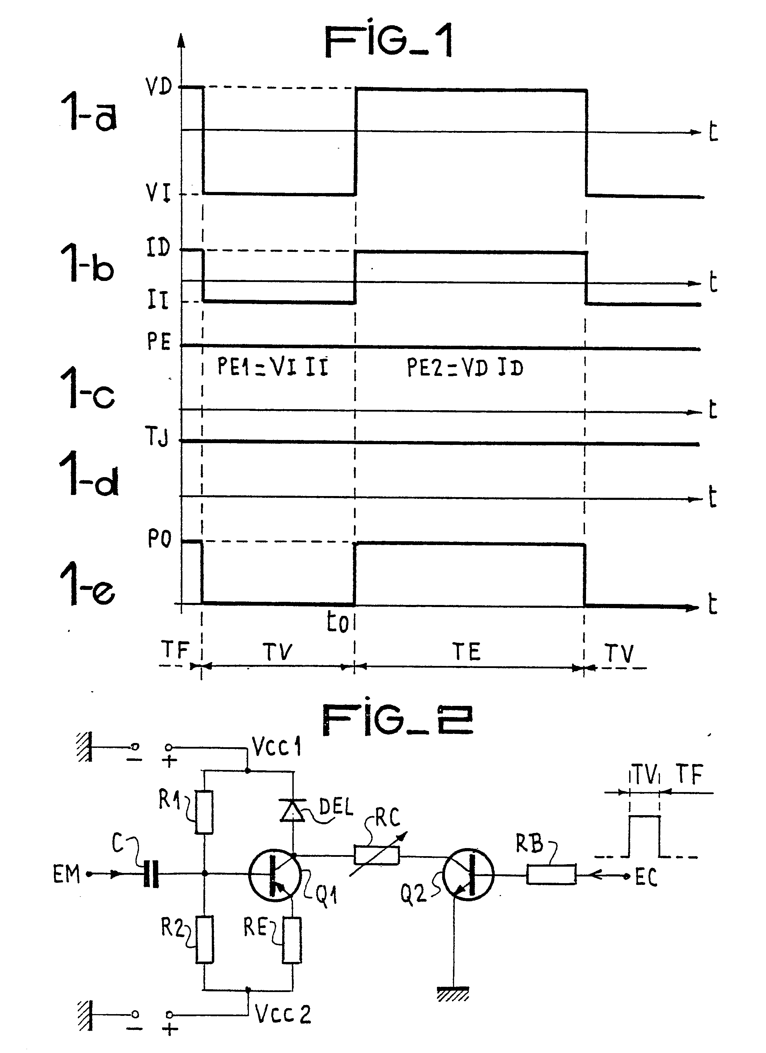

Les formes d'ondes Figs 1-a à 1-e illustrent ce fonctionnement.

La Fig. 1-a représente la tension VI aux bornes de la diode lorsqu'elle est polarisée en inverse (période d'attente ou de veille TV) et VD lorsqu'elle est polarisée en direct (période de fonctionnement ou d'émission TE). La Fig. 1-b se rapporte au courant traversant la diode, $I_i$ et $I_D$ respectivement. La Fig. 1-c montre l'égalisation de la puissance électrique en inverse $PE_1$ et en direct $PE_D$ et la Fig. 1-d la température TJ inchangée de la jonction. La puissance optique PO transmise est illustrée par la Fig. 1-e ; elle est nulle durant chaque période de veille TV par suite du blocage de l'émission par polarisation inverse ; elle atteint immédiatement la valeur désirée dès l'instant to de passage à l'état de fonctionnement du fait que la température de la jonction a été préservée durant la phase TV précédente. La valeur PO correspond à la valeur de puissance moyenne.

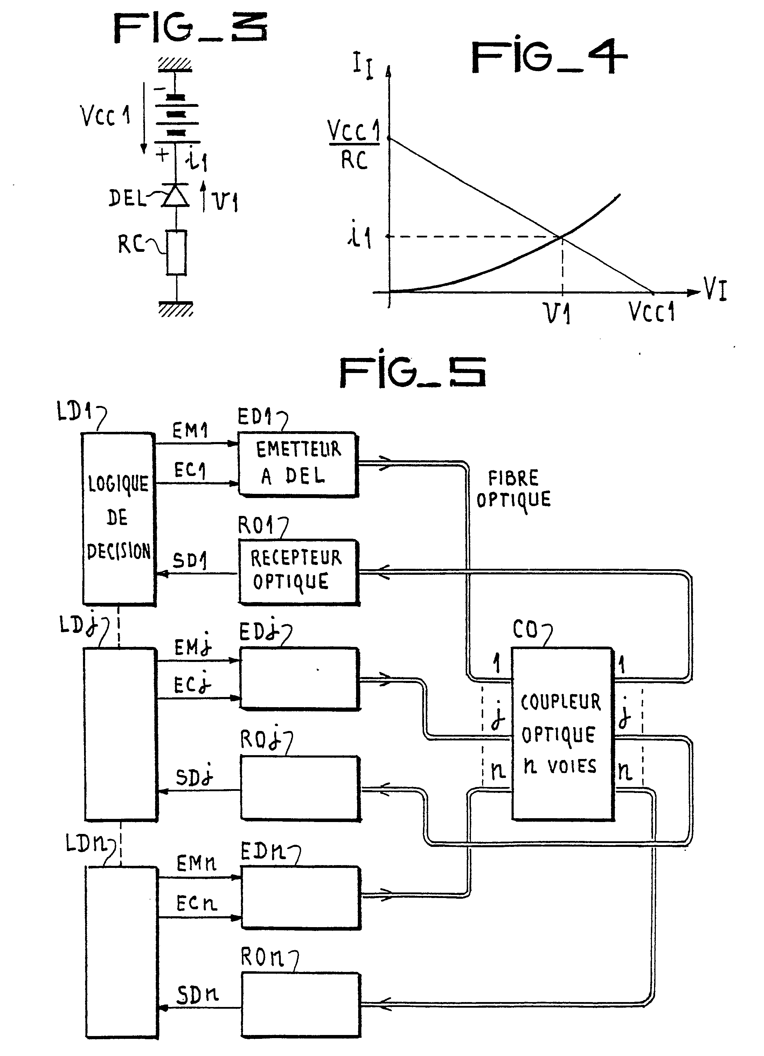

La Fig. 2 montre un exemple de réalisation d'un dispositif à diode DEL conforme à l'invention. Le dispositif représenté sous forme d'un circuit électrique comporte la diode DEL proprement dite, une entrée de modulation EM, une entrée de commande EC, deux transistors Q1 et Q2, un condensateur C et les résistance R1, R2, RE et RC.

La diode DEL est polarisée en direct par la source de courant constituée par le transistor pnp Q1, les

3

résistances RE, R1, R2 et une tension continue VC de polarité appropriée aux bornes du montage. Cette tension est obtenue avec les deux potentiels continus Vcc1 et Vcc2, positifs dans le cas considéré, et appliqués côté R1 et R2 respectivement. La tension VC produite est égale à Vcc2-Vcc1 étant entendu que Vcc2 est supérieur à Vcc1, par exemple, Vcc2 = 10 V et Vcc1 = 5 V. La branche R1-R2 assure la polarisation de la base du transistor Q1 et détermine le courant moyen Io dans la diode DEL qui charge le collecteur. La modulation est appliquée à l'entrée EM et transmise vers la base de Q1 à travers le condensateur C pour faire varier la polarisation et corrélativement le courant à travers le transistor et la diode en sorte de moduler l'émission des photons.

La polarisation inverse est réalisée par un commutateur qui a pour rôle de brancher la diode aux bornes de l'alimentation continue Vcc1. Le circuit commutateur se compose du transistor Q2 et des résistances RC et RB.

Pour produire l'état de veille une tension positive est appliquée à l'entrée EC ce qui entraîne la conduction à saturation du transistor Q2 et revient à considérer la résistance RC connectées de ce côté de la masse comme indiqué sur la Fig. 3. Les résistances RB et RC servent à limiter les courants. La diode DEL se trouve alors polarisée en inverse par la tension Vcc1.

La Fig. 4 représente la caractéristique tension-courant de la diode DEL en inverse ainsi que la droite de charge relative à la résistance RC. Le point de fonctionnement $v_1$, $i_1$ peut être réglé en faisant varier Vcc1 et/ou RC en sorte que la puissance électrique dissipée PE1 = $v_1 \cdot i_1$ durant la phase d'attente TV correspond à celle PE2 de la phase d'émission. La diode étant polarisée en inverse il n'y a pas d'émission de lumière.

Pour produire ensuite une phase d'émission TE, la tension de commande appliquée à l'entrée EC descend à OV ou à une valeur légèrement négative pour bloquer le transistor Q2 et le circuit de la diode DEL se reforme à nouveau à travers le transistor Q1. La diode DEL est polarisée par la source de courant Q1, R1, R2, RE et la valeur du courant direct est donnée par :

$$I_D = \left[ (Vcc2 - Vcc1) \cdot \frac{R2}{R1 - R2} - (V_{BE})\, Q1 \right] \frac{1}{RE}$$

$(V_{BE})Q1$ étant la tension entre base et émetteur de Q1. La tension VD aux bornes de la diode dépend peu du courant ID, et est généralement voisine de 2V. La puissance électrique dissipée PE2 est égale à ID · VD.

Si le courant ID d'une part, Vcc1 et RC d'autre part, sont choisis pour égaliser sensiblement les valeurs de puissance dissipée PE1 et PE2, la température de la jonction ne changera pratiquement pas au moment du passage de l'état de veille (DEL polarisée en inverse ; pas d'émission de lumière) à l'état de fonctionnement (DEL polarisée en direct ; émission de lumière) et le montage ne présentera pas de constante de temps thermique.

Dans une application à un bus optique, le fait que les diodes non opérationnelles à un instant considéré ne sont pas émissives entraîne à la réception d'un seul signal lumineux à la fois, celui de la diode DEL de l'émetteur opérationnel, et évite la dégradation du rapport signal sur bruit dans le rapport

$$\sqrt{\frac{Pol + \cdots + Poi + \cdots + Pon}{Poi}}$$

qui devient $\sqrt{n}$ pour n émetteurs identiques.

La Fig. 5 représente un exemple d'une telle utilisation. Le système de transmission comporte n voies, chacune avec un émetteur EDj à diode DEL, un récepteur optique ROj et une logique de décision LDj. On distingue les entrées pour commander l'un ou l'autre état et la sortie de détection SDj du récepteur. Les circuits de décision LD1 à LDn sont contrôlés à partir d'une unité centrale non représentée, ne serait ce que pour gérer dans le temps les émissions de messages. Les interconnexions optiques peuvent être réalisées avec un coupleur optique CO, par exemple un barreau mélangeur, auquel les émetteurs et récepteurs sont connectés par fibres optiques.

**Revendications**

1. Dispositif à diode émettrice de lumière, comportant un moyen de mise en service et de modulation de la diode (DEL) sur réception d'un signal de modulation, ce moyen polarisant la diode en direct pour obtenir une émission de photons modulée selon le signal, et un moyen de mise hors service de la diode durant les intervalles de temps séparant les périodes d'émission, le dispositif étant caractérisé en ce que le moyen de mise hors service (Q2, RB, RC) est déterminé pour polariser en inverse la diode en dissipant, dans sa jonction pn, une puissance électrique (PE1) sensiblement égale à la valeur de celle (PE2) qui y est dissipée durant chaque émission, et placer ainsi la diode en un état de veille (TV) durant lequel l'émission se trouve bloquée tout en assurant une température de la jonction correspondant à celle durant l'émission (TE) ce qui permet d'éviter tout effet de constante de temps thermique de la jonction.

2. Dispositif selon la revendication 1, caractérisé en ce que le moyen de mise en service et de modulation comporte une source de courant (Q1, RE, R1, R2) réalisée à l'aide d'un premier transistor (Q1) connecté par son collecteur à une électrode de la diode (DEL), et que le moyen de mise hors service comporte un commutateur (RC, Q2, RB) réalisé à l'aide d'un second transistor (Q2) dont le collecteur est connecté à la même électrode de la diode et à travers une résistance (RC).

3. Dispositif selon la revendication 2, caractérisé en ce que ladite résistance (RC) est ajustable pour régler ladite égalité des puissances électriques dissipées.

4. Dispositif selon la revendication 2 ou la revendication 3, caractérisé en ce que les moyens d'alimentation annexe produisent deux tensions continues, une première tension continue (Vcc1) appliquée à l'autre électrode de la diode (DEL) et une deuxième tension continue (Vcc2) appliquée sur l'électrode émetteur du premier transistor (Q1) à travers un élément résistif (RE).

5. Dispositif selon la revendication 4, caractérisé en ce que la deuxième tension continue (Vcc2) est supérieure à la première tension continue (Vcc1).

6. Dispositif selon la revendication 3 ou 4, caractérisé en ce que le premier transistor est de type pnp, le deuxième de type pnp, et que la deuxième tension continue (Vcc2) est supérieure à la première tension continue (Vcc1).

7. Utilisation d'un dispositif à diode émettrice de lumière (DEL) selon l'une quelconque des revendications 1 à 6 pour réaliser un système de transmission optique, dit bus optique, destiné à interconnecter une pluralité n de stations comportant chacune un émetteur (EDj) à diode émettrice de lumière, caractérisé en ce que chaque émetteur émet son information pendant que les autres émetteurs sont polarisés en inverse, n'émettant ainsi pas de lumière qui augmenterait le bruit dans les récepteurs optiques (ROj) qui équipent les stations, ces émetteurs en état de veille étant polarisés en inverse de manière à chauffer leurs jonctions à la même valeur qu'au moment de l'émission optique évitant ainsi tout délai dû à la constante de temps thermique.

## Claims

1. Light emitting diode device comprising means for activating and modulating the diode (DEL) upon reception of a modulation signal, this means polarising the diode in the forward direction to obtain an emission of photons modulated in accordance with the signal, and means for deactivating the diode during time intervals separating the emission periods, the device being characterized in that the deactivating means (Q2, RB, RC) is determined for reverse polarising the diode while dissipating in its junction an electric power (PE1) substantially equal to the value of that (PE2) which is dissipated therein during each emission, and for thus placing the diode into a stand-by state (TV) during which the emission is blocked while a junction temperature is ensured which corresponds to that during the emission (TE), which permits to avoid any effect of the thermal time constant of the junction.

2. Device according to claim 1, characterized in that the activating and modulating means comprise a current source (Q1, RE, R1, R2) formed by means of a first transistor (Q1) connected on its collector to an electrode of the diode (DEL), and that the deactivating means comprises a switch (RC, Q2, RB) formed by means of a second transistor (Q2) the collector of which is connected to the same electrode of the diode through a resistor (RC).

3. Device according to claim 2, characterized in that said resistor (RC) is adjustable to adjust said equality of the dissipated electric powers.

4. Device according to claim 2 or claim 3, characterized in that auxiliary supply means produce two direct voltages, a first direct voltage (Vcc1) applied to the other electrode of the diode (DEL) and a second direct voltage (Vcc2) applied to the emitter electrode of the first transistor (Q1) through a resistive member (RE).

5. Device according to claim 4, characterized in that the second direct voltage (Vcc2) exceeds the first direct voltage (Vcc1).

6. Device according to claim 3 or 4, characterized in that the first transistor is of pnp type, the second of npn type, and that the second direct voltage (Vcc2) exceeds the first direct voltage (Vcc1).

7. Use of a light emitting diode (DEL) device according to any of claims 1 to 6 to provide an optical transmission system, referred to as an optical bus, and intended to interconnect a plurality of n stations each comprising a transmitter (EDj) having a light emitting diode, characterized in that each transmitter transmits its information while the other transmitters are polarised in reverse direction, thus not emitting any light which would increase the noise in the optical receivers (ROj) with which the stations are equipped, these transmitters being polarised in the reverse direction in the stand-by mode so that their junctions are heated to the same value as at the moment of optical emission, thus avoiding any delay due to the thermal time constant.

## Patentansprüche

1. Vorrichtung mit Leuchtdiode, versehen mit einer Einrichtung zur Inbetriebnahme und Modulation der Diode (DEL) bei Empfang eines Modulationssignals, wobei diese Einrichtung die Diode in Durchlaßrichtung polt, um eine durch das Signal modulierte Photonenemission zu erhalten, und mit einer Einrichtung zur Außerbetriebnahme der Diode wäßhrend der Zeitintervalle, die zwischen den Emissionsperioden liegen, wobei die Vorrichtung dadurch gekennzeichnet ist, daß die Einrichtung zur Außerbetriebnahme (Q2, RB, RC) ausgelegt ist, um die Diode in Sperrichtung zu polen, indem in ihrem pn-Übergang eine elektrische Leistung (PE1) freigesetzt wird, die ungefähr gleich dem Wert derjenigen Leistung (PE2) ist, die dort während jeder Emission freigesetzt wurde, so daß die Diode in einen Bereitschaftszustand (TV) versetzt wird, während welchem die Emission unterbunden ist, wobei aber eine Temperatur der Überganges gewährleistet wird, die derjenigen während des Sendebetriebs (TE) entspricht, wodurch jegliche Auswirkung der thermischen Zeitkonstante des Überganges vermieden werden kann.

2. Vorrichtung nach Anspruch 1, dadurch gekennzeichnet, daß die Einrichtung zur Inbetriebnahme und Modulation eine Stromquelle (Q1, RE, R1, R2) umfaßt, die mittels eines ersten Transistors (Q1) verwirklicht ist, welcher an seinem Kollektor mit einer Elektrode der Diode (DEL) verbunden ist, und daß die Einrichtung zur Außerbetriebnahme einen Schalter (RC, Q2, RB) umfaßt, der mittels eines zweiten Transistors (Q2) verwirklicht ist, dessen Kollektor über einen Widerstand (RC) mit derselben Elektrode der Diode verbunden ist.

3. Vorrichtung nach Anspruch 2, dadurch gekennzeichnet, daß der genannte Widerstand (RC) einstellbar ist, um die genannte Gleichheit der freigesetzten elektrischen Leistungen einzustellen.

4. Vorrichtung nach Anspruch 2 oder Anspruch 3, dadurch gekennzeichnet, daß die Hilfsversorgungsmittel zwei Gleichspannungen erzeugen, eine erste Gleichspannung (Vcc1), die an die andere Elektrode der Diode (DEL) angelegt wird, und eine zweite Gleichspannung (Vcc2), die an die Emitterelektrode des ersten Transistors (Q1) über ein resistives Element (RE) angeschlossen ist.

5. Vorrichtung nach Anspruch 4, dadurch gekennzeichnet, daß die zweite Gleichspannung (Vcc2) größer als die erste Gleichspannung (Vcc1) ist.

6. Vorrichtung nach Anspruch 3 oder 4, dadurch gekennzeichnet, daß der erste Transistor vom Typ pnp ist und der zweite vom Typ npn, und daß die zweite Gleichspannung (Vcc2) größer als die erste Gleichspannung (Vcc1) ist.

7. Verwendung einer Vorrichtung mit Leuchtdiode (DEL) gemäß einem der Ansprüche 1 bis 6 zur Verwirklichung eines optischen Übertragungssystems, das als optischer Bus bezeichnet wird und dazu bestimmt ist, eine Mehrzahl von n Stationen zu verbinden, die jeweils einen Sender (EDj) mit Leuchtdiode umfassen, dadurch gekennzeichnet, daß jeder Sender seine Information aussendet, während die anderen Sender in Sperrichtung gepolt sind, so daß sie kein Licht aussenden, wodurch das Rauschen in den optischen Empfängern (ROj) vergrößert würde, mit denen die Stationen ausgestattet sind, wobei diese Sender im Bereitschaftszustand in Sperrichtung derart gepolt sind, daß ihre Übergänge auf denselben Wert wie zum Zeitpunkt der Lichtemission erwärmt werden, so daß jede Verzögerung vermieden wird, welche auf der thermischen Zeitkonstante beruht.

# FIG_1

# FIG_2

# FIG_3

# FIG_4

# FIG_5